(19) Europäisches Patentamt
European Patent Office
Office européen des brevets

(11) **EP 4 571 331 B1**

(12) **EUROPÄISCHE PATENTSCHRIFT**

(45) Veröffentlichungstag und Bekanntmachung des Hinweises auf die Patenterteilung:
**25.02.2026 Patentblatt 2026/09**

(21) Anmeldenummer: **24217495.1**

(22) Anmeldetag: **04.12.2024**

(51) Internationale Patentklassifikation (IPC):
**G01R 31/28** (2006.01) **G01R 31/34** (2020.01)
**G01R 31/42** (2006.01)

(52) Gemeinsame Patentklassifikation (CPC):
**G01R 31/343; G01R 31/2846; G01R 31/42**

(54) **VERFAHREN ZUR SIMULATION EINES MEHRPHASIGEN E-ANTRIEBS MIT BESTROMBAREN STRÄNGEN MITTELS EINES HIL-SIMULATORS ZUM TEST EINES LEISTUNGSELEKTRONISCHEN STEUERGERÄTS MIT INTEGRIERTEM WECHSELRICHTER**

METHOD FOR SIMULATING MULTIPHASE ELECTRIC DRIVE WITH STRANDS BY MEANS OF A HIL SIMULATOR FOR TESTING A POWER ELECTRONIC CONTROL DEVICE WITH INTEGRATED INVERTER

PROCÉDÉ POUR SIMULER UN ENTRAÎNEMENT ÉLECTRIQUE POLYPHASÉ À BRINS ÉLECTRIQUES AU MOYEN D'UN SIMULATEUR HIL DANS LA BOUCLE POUR TESTER UN APPAREIL DE COMMANDE ÉLECTRONIQUE DE PUISSANCE INTÉGRÉ

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **11.12.2023 DE 102023134664**

(43) Veröffentlichungstag der Anmeldung:
**18.06.2025 Patentblatt 2025/25**

(73) Patentinhaber: **dSPACE GmbH**
**33102 Paderborn (DE)**

(72) Erfinder: **Geng, Stefan**
**33102 Paderborn (DE)**

(56) Entgegenhaltungen:
**DE-A1- 102020 131 260 US-A1- 2023 359 785**

**EP 4 571 331 B1**

**Beschreibung**

Die Erfindung betrifft ein Computerimplementiertes Verfahren zur Simulation eines mehrphasigen elektrischen Antriebs mit bestrombaren Strängen mittels eines Hardware-in-the-Loop-Simulators zum Test eines leistungselektronischen Steuergeräts mit integriertem Wechselrichter, wobei das Steuergerät wenigstens drei Speiseanschlüsse aufweist und der Wechselrichter des Steuergeräts im Testbetrieb in zeitlichen Abschnitten einen Speiseanschluss der drei Speiseanschlüsse auf ein hohes Wechselrichterpotential schaltet, einen anderen Speiseanschluss der drei Speiseanschlüsse auf ein niedriges Wechselrichterpotential schaltet und noch einen anderen Speiseanschluss der drei Speiseanschlüsse potentialfrei schaltet, wobei im Testbetrieb die Speiseanschlüsse des Steuergeräts mit korrespondierenden Stranganschlüssen des Simulators verbunden sind, wobei die Strangspannungen der Stranganschlüsse im Simulator messtechnisch erfasst werden, wobei der Simulator mit einem mathematischen Modell des elektrischen Antriebs und dessen Strängen anhand der gemessenen Strangspannungen korrespondierende Strangströme des Antriebs berechnet, wobei im Simulator durch Auswertung der Strangspannungen und/oder der Strangströme ermittelt wird, welcher Stranganschluss mit dem potentialfreien Speiseanschluss des Steuergeräts verbunden und daher ein potentialfreier Stranganschluss ist, wobei der Simulator ein sich aus der Antriebsrückwirkung ergebendes elektrisches Rückwirkungspotential des potentialfreien Stranganschlusses ermittelt und mittels eines Spannungsemulators den potentialfreien Stranganschluss auf das ermittelte Rückwirkungspotential legt und wobei der Simulator in die nicht potentialfreien Stranganschlüsse die berechneten Strangströme mittels eines Stromemulators einspeist.

US 2023 359785 A1 offenbart ein computerimplementiertes Verfahren zur Simulation eines elektrischen Antriebs mittels wenigstens einer Recheneinheit eines Hardware-in-the-Loop-Simulators.

Das zuvor beschriebene computerimplementierte Verfahren ist angesiedelt im technischen Bereich der Echtzeitsimulation von elektrischen Schaltungen, vorliegend in Form eines mehrphasigen elektrischen Antriebes, zum Zweck der Beeinflussung oder des Tests von leistungselektronischen Steuergeräten, wie sie in großer Zahl in Kraftfahrzeugen, Flugzeugen, Energiegewinnungsoder Energieverteilungsanlagen usw. zum Einsatz kommen. Der betrachtete Anwendungsfall des computerimplementierten Verfahrens ist die Hardware-in-the-Loop-Simulation (HIL-Simulation). Wenn das eingangs beschriebene computerimplementierte Verfahren im Rahmen einer HIL-Simulation durchgeführt wird, dann wird die Simulation durch Berechnung des mathematischen Modells des elektrischen Antriebs, also des Modells in Form numerisch auf einem Rechner berechenbarer Gleichungen, auf einer Recheneinheit - oder ggf. auch auf mehreren Recheneinheiten - des HIL-Simulators durchgeführt. Der HIL-Simulator täuscht dem angeschlossenen leistungselektronischen Steuergerät die technische Umgebung vor, in der das zu testende Steuergerät später tatsächlich eingesetzt werden soll, hier also den mehrphasigen elektrischen Antrieb.

Da vorliegend der Test des Steuergeräts auf Leistungsebene erfolgt, umfasst der Simulator neben dem mathematischen Modell des Antriebs, das auf einer geeigneten Recheneinheit berechnet wird, auch leistungselektronische Komponenten, nämlich in Form der genannten Spannungs- und Stromemulatoren. Im Testbetrieb ist das Steuergerät elektrisch mit dem Simulator verbunden, indem, wie eingangs beschrieben, die Speiseanschlüsse des Steuergeräts mit korrespondierenden Stranganschlüssen des Simulators verbunden sind.

In dem Simulator werden die Strangspannungen an den Stranganschlüssen messtechnisch erfasst. Die gemessenen Strangspannungen sind - jedenfalls auch - numerische Eingangsgrößen des mathematischen Modells des elektrischen Antriebes, mit dem dann die elektrischen und mechanischen Zustandsgrößen des Antriebs berechnet werden. Zu den elektrischen Zustandsgrößen zählen die resultierenden Strangströme in den Strängen des simulierten Antriebs. Je nach Betriebszustand des Antriebs kann eine elektrische Leistung von dem Steuergerät in den Simulator (motorischer Betrieb des Antriebs) oder auch elektrische Leistung von dem Simulator in das Steuergerät (generatorischer Betrieb des Antriebs) getrieben werden. Der Begriff der Speiseanschlüsse des Steuergeräts ist also nicht einschränkend hinsichtlich einer Richtung des Energieflusses zu verstehen.

Der Wechselrichter des Steuergeräts wird über einen Gleichstromzwischenkreis gespeist, der das hohe und das niedrige Wechselrichterpotential bereitstellt. Indem in bestimmter zeitlicher Abfolge die verschiedenen Wechselrichterpotentiale auf die Speiseanschlüsse des Steuergeräts geschaltet werden, lassen sich dort gezielt Spannungs-Zeit-Flächen und damit gewünschte Ströme in Zusammenhang mit angeschlossenen Spulen realisieren. Wichtig ist hier, dass das leistungselektronische Steuergerät mit dem Wechselrichter ein solches Anregungsschema realisiert, bei dem einer der Speiseanschlüsse - was den direkten Einfluss des Steuergerätes betrifft - potentialfrei geschaltet ist, also weder mit dem hohen noch mit dem niedrigen Wechselrichterpotential verbunden ist, sondern hochohmig von den Wechselrichterpotentialen abgetrennt ist; der betreffende Speiseanschluss ist "floatend", über ihn kann auch kein Strom fließen. Derartige Anregungsschemata werden verwendet, um beispielsweise permanenterregte Drehstrom-Synchronmaschinen anzusteuern, in der Praxis sind dies häufig bürstenlose Gleichstrommotoren (BLDC = brushless DC), die blockkommutiert angesteuert werden.

Der Speiseanschluss des Steuergeräts, der - was die Wirkung des Steuergeräts betrifft - potentialfrei geschaltet ist und damit natürlich auch der mit diesem Speiseanschluss verbundene korrespondierende Stranganschluss des Simulators tragen kein elektrisches Potential, das direkt von dem Steuergerät vorgegeben wird. Das elektrische Potential

EP 4 571 331 B1

an diesen Anschlüssen wird - bei einem echten elektrischen Antrieb - vielmehr bestimmt durch die Antriebsrückwirkung, also die in dem freigeschalteten Strang induzierte elektromotorische Gegenspannung. Bei dem simulierten Antrieb wird durch Auswertung der Strangspannungen und/oder der Strangströme ermittelt, welcher der Stranganschlüsse mit dem potentialfreien Speiseanschluss des Steuergerätes verbunden und daher der potentialfreie Stranganschluss ist. Daraufhin wird mithilfe des mathematischen Modells des Antriebs das sich aus der Antriebsrückwirkung ergebende elektrische Rückwirkungspotential des potentialfreien Stranganschlusses ermittelt, und mittels des Spannungsemulators wird der potentialfreie Stranganschluss auf das ermittelte Rückwirkungspotential gelegt. In die nicht potentialfreien Stranganschlüsse, über die auch Ströme fließen können, weil sie im Steuergerät mit jeweils einem der Wechselrichterpotentiale verbunden sind, speist der Simulator die berechneten Strangströme mittels des Stromemulators ein.

Die Berechnung des sich aus der Antriebsrückwirkung ergebenden Rückwirkungspotentials erfolgt meist auf Grundlage bestimmter Annahmen. Eine häufig unterstellte Voraussetzung ist beispielsweise, dass der simulierte Antrieb magnetisch symmetrisch ist, dass also die Induktivitäten der Wicklungen der Stränge des bestrombaren Antriebs gleich sind. Im rotorfesten dq-Koordinatensystem mit nur zwei Phasen (weil sich bei Sternschaltung der Antriebsstränge die elektrischen Größen eines Antriebsstrangs stets aus den elektrischen Größen der beiden anderen Stränge ergeben) bedeutet dies, dass für die transformierten Induktivitäten Ld, Lq gilt Ld = Lq. Trifft dies jedoch nicht zu, werden die Rückwirkungspotentiale ggf. unzutreffend berechnet, was auf Seiten des Simulators die Folge unzutreffend berechneter Strangströme (auch in dem eigentlich potentialfreien und stromlosen Strang) führen kann.

Aufgabe der vorliegenden Erfindung ist es daher, das Verfahren zur Simulation eines mehrphasigen Antriebs und den entsprechenden Simulator so auszugestalten und weiterzubilden, dass der Einfluss ungenau berechneter Rückwirkungspotentiale auf die Simulation reduziert wird.

Die hergeleitete Aufgabe ist bei dem eingangs beschriebenen Verfahren zunächst dadurch gelöst, dass das mathematische Modell des elektrischen Antriebs in den Strängen jeweils durch einen virtuellen Schalter ergänzt ist, wobei die virtuellen Schalter im geöffneten Zustand den Einfluss der zugehörigen gemessenen Strangspannungen auf die berechneten Stromflüsse in dem jeweiligen Strang reduzieren und wobei die virtuellen Schalter in den Strängen des elektrischen Antriebs von einer Schaltlogik des Simulators durch Auswertung wenigstens einer Strangspannung und/oder eines Strangstromes geöffnet und/oder geschlossen werden.

Durch Einsatz der virtuellen Schalter kann der Einfluss einer fehlerhaften Strangspannung (oder auch mehrerer fehlerhafter Strangspannungen), die messtechnisch ermittelt und als gemessene Strangspannung an das mathematische Modell des Antriebs weitergegeben wird und daher auch auf die Berechnung der Strangströme Einfluss hat, reduziert werden, nämlich indem der betreffende virtuelle Schalter geöffnet wird, also der Schalter in dem Antriebsstrang, an dem die fehlerhafte Strangspannung anliegt. Durch die Schaltlogik des Simulators und die damit verbundene Auswertung wenigstens einer Strangspannung und/oder eines Strangstromes können die virtuellen Schalter in den Strängen des elektrischen Antriebs bedarfsgerecht betätigt, also geöffnet und/oder geschlossen werden, um gezielt die fehlerhafte Strangspannung im Rahmen der Berechnung des Modells in ihrem Einfluss auf das mathematische Modell zu reduzieren.

Bei einer Weiterbildung des Verfahrens wird der virtuelle Schalter in dem Modell eines Strangs des Antriebs durch einen ohmschen Widerstand repräsentiert, dessen Widerstandswert vom Schaltzustand des virtuellen Schalters abhängt. Dadurch wird bewirkt, dass eine Strukturumschaltung des mathematischen Modells bei Änderung des Schaltzustandes eines virtuellen Schalters oder auch mehrerer virtueller Schalter nicht erforderlich ist. Das bedeutet, dass die dem mathematischen Modell zugrunde liegenden Gleichungen von ihrer Struktur unverändert bleiben, lediglich Parameter des Modells, also die Widerstandswerte der virtuellen Schalter, werden in Abhängigkeit von dem Schaltzustand variiert.

Eine bevorzugte Ausgestaltung des Verfahrens zeichnet sich dadurch aus, dass die Schaltlogik des Simulators denjenigen Stranganschluss erkennt, der potentialfrei ist, also mit dem potentialfreien Speiseanschluss des Steuergeräts verbunden ist, und den virtuellen Schalter desjenigen Strangs öffnet, dessen Stranganschluss potentialfrei ist. Diese konkrete Ausgestaltung zielt auf die Problematik ab, dass das sich aus der Antriebsrückwirkung ergebende Rückwirkungspotential nicht richtig berechnet wird und demzufolge das elektrische Potential, auf das der Spannungsemulator den potentialfreien Stranganschluss legt, nicht richtig eingestellt wird.

Bei einer Weiterbildung des zuvor genannten Verfahrens ist ferner vorgesehen, dass die Schaltlogik des Simulators auswertet, ob eine Voraussetzung für die korrekte Ermittlung des Rückwirkungspotentials am potentialfreien Stranganschluss im tatsächlichen Betriebszustand des elektrischen Antriebs erfüllt ist und bei Nichterfüllung der Voraussetzung für die korrekte Ermittlung des Rückwirkungspotentials den virtuellen Schalter desjenigen Strangs öffnet, dessen Stranganschluss potentialfrei ist. Durch diese Maßnahme ist der Einsatz der virtuellen Schalter gezielt einsetzbar, nämlich beschränkt auf Situationen, bei denen die Voraussetzung für die korrekte Ermittlung des Rückwirkungspotentials nicht gegeben ist. Die Schaltlogik könnte das mathematische Modell des elektrischen Antriebs beispielsweise daraufhin untersuchen, ob der elektrische Antrieb magnetisch symmetrisch ist, ob also die Induktivitäten Ld, Lq in den Strängen des Antriebs im zweiphasigen dq-System gleich sind (Ld = Lq).

Gemäß einer weiteren vorteilhaften Ausgestaltung des Verfahrens werden die Widerstandswerte der virtuellen

3

Schalter für den offenen und den geschlossenen Schaltzustand so gewählt, dass das mathematische Modell des elektrischen Antriebs mit expliziten numerischen Lösungsverfahren stabil gelöst werden kann, insbesondere bei vorgegebener Berechnungsschrittweite, vorzugsweise unter Echtzeitbedingungen.

Alternativ kann auch ein implizites numerisches Verfahren auf das Motormodell angewendet werden. In diesem Fall können die Widerstandswerte in weiteren Grenzen gewählt werden. Da dann in jedem Integrationsschritt ein zusätzlicher Berechnungsaufwand auftritt (iteratives Verfahren zur Lösung der numerischen impliziten Gleichung oder analytisches Verfahren mit dann erforderlicher Matrizeninvertierung), ergeben sich möglicherweise Konflikte mit Echtzeitanforderungen an die Berechnung.

Bevorzugt wird das aufgezeigte Verfahren verwendet in Zusammenhang mit einem simulierten elektrischen Antrieb, der eine mehrphasige, insbesondere dreiphasige, permanenterregte Synchronmaschine ist, der insbesondere ein bürstenloser Gleichstrommotor ist. Die Stränge des Antriebes sind üblicherweise im Stern oder Dreieck zusammengeschaltet.

Die zuvor hergeleitete Aufgabe wird auch gelöst mit einem Hardware-in-the-Loop Simulator zur computerimplementierten Simulation eines mehrphasigen elektrischen Antriebs mit bestrombaren Strängen zum Test eines leistungselektronischen Steuergeräts mit integriertem Wechselrichter, mit dem das zuvor dargestellte Verfahren durchgeführt wird. Das Steuergerät gehört nicht mit zum Simulator, die Funktionsweise des Simulators ist aber nur in Zusammenwirken mit dem Steuergerät verständlich. Das Steuergerät weist wenigstens drei Speiseanschlüsse auf und der Wechselrichter des Steuergeräts schaltet im Testbetrieb in zeitlichen Abschnitten einen Speiseanschluss der drei Speiseanschlüsse auf ein hohes Wechselrichterpotential, einen anderen Speiseanschluss der drei Speiseanschlüsse auf ein niedriges Wechselrichterpotential und noch einen anderen Speiseanschluss der drei Speiseanschlüsse potentialfrei, wobei im Testbetrieb, also bei Durchführung des Tests des Steuergeräts durch den Simulator, die Speiseanschlüsse des Steuergeräts mit korrespondierenden Stranganschlüssen des Simulators verbunden sind. Die Strangspannungen der Stranganschlüsse werden im Simulator messtechnisch erfasst, wobei der Simulator auf einer Recheneinheit mit einem mathematischen Modell des elektrischen Antriebs und dessen Strängen anhand der gemessenen Strangspannungen korrespondierende Strangströme des Antriebs berechnet. Im Simulator wird durch Auswertung der Strangspannungen und/oder der Strangströme ermittelt, welcher Stranganschluss mit dem potentialfreien Speiseanschluss des Steuergeräts verbunden und daher ein potentialfreier Stranganschluss ist. Der Simulator ermittelt das sich aus der Antriebsrückwirkung ergebende elektrische Rückwirkungspotential des potentialfreien Stranganschlusses. Der Simulator legt mittels eines Spannungsemulators den potentialfreien Stranganschluss auf das ermittelte Rückwirkungspotential und der Simulator speist in die nicht potentialfreien Stranganschlüsse die berechneten Strangströme mittels eines Stromemulators ein. Der Simulator ist so ausgestaltet ist, dass er im Testbetrieb, also mit angeschlossenem leistungselektronischem Steuergerät, das zuvor ausführlich dargestellte Verfahren durchführt.

Die Erfindung betrifft ferner auch ein Computerprogramm, umfassend Befehle, die bei der Ausführung des Programms durch eine Recheneinheit eines Hardware-in-the-Loop-Simulators diese veranlassen, das zuvor erläuterte Verfahren auszuführen.

Im Einzelnen gibt es nun eine Vielzahl von Möglichkeiten, das erfindungsgemäße Verfahren zur Simulation eines mehrphasigen elektrischen Antriebs mit bestrombaren Strängen mittels eines Hardware-in-the-Loop-Simulators und einen entsprechenden Hardware-in-the-Loop-Simulator zum Test eines leistungselektronischen Steuergeräts auszugestalten und weiterzubilden. Dazu wird verwiesen, einerseits auf die den unabhängigen Patentansprüchen nachgeordneten Patentansprüche, andererseits auf die folgende Beschreibung von Ausführungsbeispielen in Verbindung mit der Zeichnung. In der Zeichnung zeigen

Fig. 1 schematisch ein computerimplementiertes Verfahren zur Simulation eines mehrphasigen elektrischen Antriebs mit bestrombaren Strängen mittels eines Hardware-in-the-Loop-Simulators zum Test eines leistungselektronischen Steuergeräts sowie einen entsprechenden Simulator mit angeschlossenem Steuergerät,

Fig. 2 berechnete Strangspannungen und Strangströme für einen magnetisch unsymmetrischen Antrieb (Ld ungleich Lq), einmal unter der fehlerhaften Annahme eines magnetisch symmetrischen Antriebs und einmal unter korrekter Berücksichtigung der magnetischen Asymmetrie des Antriebs,

Fig. 3 ein Verfahren zur Simulation des elektrischen Antriebs unter Verwendung von virtuellen Schaltern und

Fig. 4 das Verfahren gemäß Fig. 3 bei Realisierung der virtuellen Schalter als ohmsche Widerstände mit veränderlichen, vom Schaltzustand des jeweiligen virtuellen Schalters abhängigen Widerstandswerten.

In den Figuren sind schematisch verschiedene Aspekte eines computerimplementierten Verfahrens 1 zur Simulation eines mehrphasigen elektrischen Antriebs mit bestrombaren Strängen mittels eines Hardware-in-the-Loop-Simulators 2 zum Test eines leistungselektronischen Steuergeräts 3 mit integriertem Wechselrichter 4 dargestellt.

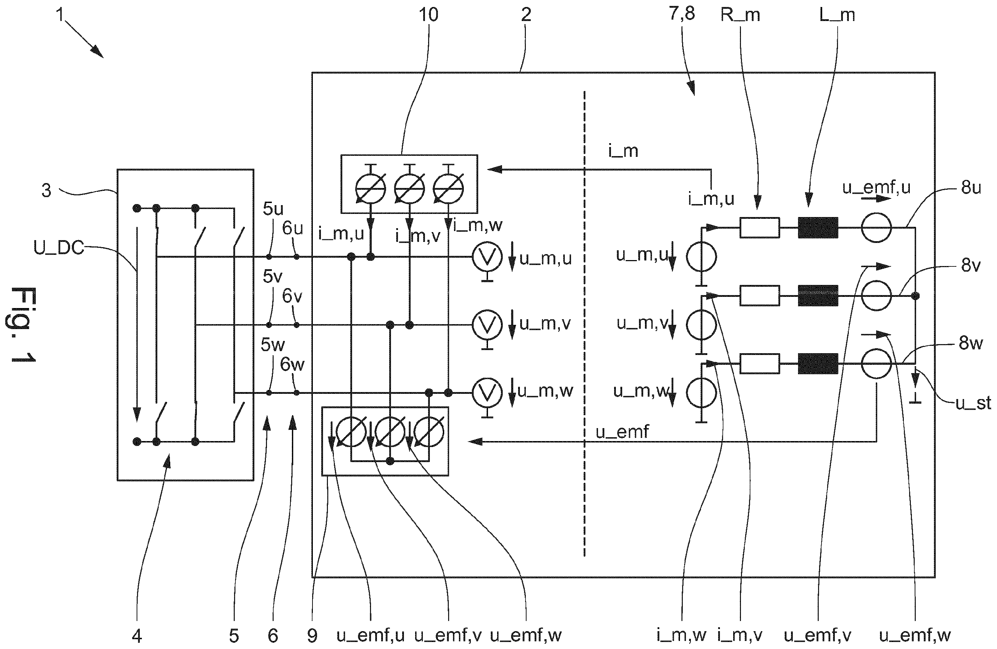

Fig. 1 zeigt ein aus dem Stand der Technik bekanntes Verfahren 1 und einen Simulator 2, mit dem das Verfahren 1 realisiert wird. Der Simulator 2 wie auch das zu testende Steuergerät 3 liegen physikalisch als miteinander verbundene Geräte vor. Der zu simulierende mehrphasige Antrieb liegt an sich nicht vor, der Antrieb wird durch den Simulator 2 hinsichtlich seines elektrischen Verhaltens nachgebildet. Die Anordnung gestattet demnach den Test des leistungselektronischen Steuergeräts 3, das typischerweise ein Serien- oder auch ein Entwicklungssteuergerät ist, ohne dass das Steuergerät 3 mit seiner echten Einsatzumgebung verbunden ist und ohne dass die echte Einsatzumgebung überhaupt verfügbar sein muss, worin der erhebliche Vorteil von Hardware-in-the-Loop-Simulationen besteht.

Die Wechselrichterpotentiale des in dem Steuergerät 3 enthaltenen Wechselrichters 4 werden gebildet durch eine Zwischenkreisgleichspannung U_DC. Das Steuergerät wird üblicherweise von extern mit Energie versorgt, wovon die Zwischenkreisspannung U_DC dann direkt oder indirekt abgeleitet wird, was hier im Einzelnen nicht dargestellt und auch nicht von Interesse ist.

Das Steuergerät 3 weist drei Speiseanschlüsse 5 auf wobei der Wechselrichter 4 des Steuergeräts 3 im Testbetrieb in zeitlichen Abschnitten einen Speiseanschluss 5u der drei Speiseanschlüsse 5 auf ein hohes Wechselrichterpotential schaltet, einen anderen Speiseanschluss 5v der drei Speiseanschlüsse 5 auf ein niedriges Wechselrichterpotential schaltet und noch einen anderen Speiseanschluss 5w der drei Speiseanschlüsse 5 potentialfrei schaltet. In Fig. 1 ist exemplarisch nur eine Schalterkonfiguration des Wechselrichters dargestellt, es versteht sich von selbst, dass die drei Speiseanschlüsse 5 des Steuergeräts 3 zeitlich abwechselnd mit dem niedrigen und dem hohen Wechselrichterpotential beaufschlagt werden bzw. potentialfrei geschaltet werden, was der bekannten Funktionsweise von Wechselrichtern entspricht.

Im Testbetrieb sind die Speiseanschlüsse 5u, 5v, 5w des Steuergeräts 3 mit korrespondierenden Stranganschlüssen 6u, 6v, 6w des Simulators 2 verbunden, sodass das Steuergerät 3 mit dem Simulator 2 physikalisch wechselwirken kann. Die Strangspannungen u_m,u, u_m,v, u_m,w der Stranganschlüsse 6u, 6v, 6w werden im Simulator 2 messtechnisch erfasst. Der Simulator 2 berechnet mit einem mathematischen Modell 7 des elektrischen Antriebs und dessen Strängen 8 anhand der gemessenen Strangspannungen u_m korrespondierende Strangströme i_m des Antriebs.

Im vorliegenden Fall ist der simulierte elektrische Antrieb eine dreiphasige, permanenterregte Synchronmaschine. Das mathematische Modell 7 des elektrischen Antriebs ist in Fig. 1 symbolisiert durch ein elektrisches Ersatzschaltbild des elektrischen Antriebs von drei in Stern geschalteten Antriebssträngen 8. Jeder Antriebsstrang 8 wird im elektrischen Ersatzschaltbild beschrieben durch eine Reihenschaltung eines ohmschen Strangwiderstandes R_m, einer Strangindukitivät L_m und die in dem jeweiligen Strang 8 induzierte Rückwirkungsspannung u_emf. Am Eingang eines jeden Antriebsstrangs 8, also an der vom Sternpunkt abgewandten Seite der Serienschaltung, liegt die jeweilige Strangspannung u_m an.

Die gleichungsmäßige Übertragung der Ersatzschaltung stellt dann das mathematische Modell 7 dar, mit dessen Hilfe die Zustandsgrößen des elektrischen Antriebs berechnet werden können.

Im Simulator 2 wird in an sich bekannter Weise durch Auswertung der Strangspannungen u_m und/oder der Strangströme i_m ermittelt, welcher Stranganschluss 6 mit dem potentialfreien Speiseanschluss 5w des Steuergeräts 3 verbunden und daher ein potentialfreier Stranganschluss 6w ist. Dies ist für die Simulation des elektrischen Antriebs wichtig, da der potentialfreie Stranganschluss 6w und die potentialtragenden Anschlüsse 6u, 6v unterschiedlich behandelt werden. Der Simulator 2 berechnet ein sich aus der Antriebsrückwirkung ergebendes elektrisches Rückwirkungspotential u_emf,w des potentialfreien Stranganschlusses 6w und legt mittels eines Spannungsemulators 9 den potentialfreien Stranganschluss 6w auf das ermittelte Rückwirkungspotential u_emf,w. Zu beachten ist hier, dass die Rückwirkungspotentiale u_emf nicht auf Masse bezogen sind (im Gegensatz zu den Strangspannungen u_m), sondern als Bezugspunkt den gemeinsamen Sternpunkt der Stränge des Antriebs haben; dies ist in den Figuren auch so dargestellt. Allgemein ergibt sich die Spannung u_m am offenliegenden Stranganschluss 6 durch Überlagerung der Spannungen u_m an den geschalteten Speiseanschlüssen 5 (bzw. an den korrespondierenden Stranganschlüssen 6) und der durch den Spannungsemulator jeweils aufgeschalteten Rückwirkungspotentiale u_emf. In die nicht potentialfreien Stranganschlüsse 6u, 6v speist der Simulator 2 die berechneten Strangströme i_m,u, i_m,v mittels eines Stromemulators 10 ein. Fig. 1 ist auch in dieser Hinsicht schematisch, als dass weitere Details zur Realisierung der Simulation der Übersicht halber weggelassen worden sind. So ist beispielsweise nicht dargestellt, dass üblicherweise Schaltmittel zwischen den Anschlüssen des Stromemulators 9 und den Stranganschlüssen 6 des Simulators 2 (und auch Schalter zwischen den Anschlüssen des Spannungsemulators 9 und den Stranganschlüssen 6 des Simulators 2) vorgesehen sind, die es ermöglichen, diejenige Stromquelle, die mit dem potentialfreien Stranganschluss 6w verbunden ist, von dem potentialfreien Stranganschluss 6w zu trennen, wodurch verhindert wird, dass der Stromemulator 10 und der Spannungsemulator 9 auf einem Stranganschluss gegeneinander arbeiten.

Es ist eingangs erläutert worden, dass sich eine problematische Situation ergeben kann, wenn bestimmte Voraussetzungen, die der Berechnung der sich aus der Antriebsrückwirkung ergebenden Rückwirkungspotentiale nicht oder in nicht ausreichendem Maße gegeben sind, sodass die Rückwirkungspotentiale nicht richtig berechnet werden, was sich wiederum auf die Berechnung der Strangströme negativ auswirken kann. Um die Problematik zu verdeutlichen, werden die elektrischen Verhältnisse der in Fig. 1 angegebenen Ersatzschaltung gleichungsmäßig betrachtet. Es wird davon ausgegangen, dass die Stränge 8u, 8v bestromt sind und der Strang 8w seitens des Steuergeräts 3 potentialfrei geschaltet und damit (abgesehen von kurzzeitig fließenden Strömen über Freilaufdioden im Wechselrichter) stromlos ist. Von Interesse sind daher die Strangspannung u_m,w und die Rückwirkungsspannung u_emf,w.

Für die Sternpunktspannung ergibt sich bei Betrachtung der Stränge 8u und 8v (Gleichung 1):

$$u\_m,w = u\_emf,w + \frac{1}{2}\left(u\_m,u + u\_m,v - u\_emf,u - u\_emf,v\right)$$

Für die Strangspannung u_m,w des potentialfrei geschalteten Strangs 8w, der stromlos ist, gilt der Zusammenhang u_m,w = u_emf,w + u_st. Wenn vereinfachend angenommen wird, dass R_m,u gleich R_m,v ist und mit dem Wissen, dass i_m,u gleich -i_m,v ist, folgt (Gleichung 2):

$$u\_st = \frac{1}{2}\left(-u\_emf,u - u\_emf,v - L\_m,u\frac{di\_m,u}{dt} - L\_m,v\frac{di\_m,v}{dt}\ldots\right.$$

$$\left.\ldots - R\_m,u \cdot i\_m,u - R\_m,v \cdot i\_m,v + u\_m,u + u\_m,v\right)$$

Wird lediglich die Grundwelle des magnetischen Flusses in dem Antrieb berücksichtigt und eine magnetisch symmetrische Maschine zugrunde gelegt, lassen sich die Induktivitäten L_m aufgrund der Symmetrieeigenschaften des Dreiphasensystems als identische Konstanten betrachten, es gilt also L_m,u = L_m,v = Lm,w. Im üblicherweise zur mathematischen Beschreibung von elektrischen Antrieben verwendeten rotorfesten dq-Koordinaten gilt dann entsprechen Ld = Lq. Die durch die Induktivitäten verursachten Spannungsabfälle heben sich gegenseitig auf, sodass für die Annahme einer magnetisch symmetrischen Maschine gilt (Gleichung 3):

$$u\_m,w = u\_emf,w + \frac{1}{2}\left(-u\_emf,u - u\_emf,v + L\_m,u\frac{di\_m,v}{dt}\ldots\right.$$

$$\left.- L\_m,v\frac{di\_m,v}{dt} + u\_m,u + u\_m,v\right)$$

Der Zusammenhang gilt natürlich für jeden potentialfrei geschalteten Strang, unabhängig davon, ob dies Strang 8u, 8v oder 8w ist. In der Schaltsituation in Fig. 1 entspricht u_m,v dem niedrigen Wechselrichterpotential, üblicherweise der elektrischen Gerätemasse, und u_m,u entspricht dem hohen Wechselrichterpotential. Dies ist keine konstante Gleichspannung, sondern ein hochfrequentes PWM-Signal, um den Strangstrom in weiten Bereichen einstellen zu können.

Bei dem Ausführungsbeispiel gemäß Fig. 1 wird das Rückwirkungspotential des aus Sicht des Steuergeräts 3 jeweils floatend geschalteten Stranges berechnet gemäß Gleichung 3 und der Spannungsemulator 9 schaltet eine entsprechende Spannung auf den betreffenden floatenden Strang auf.

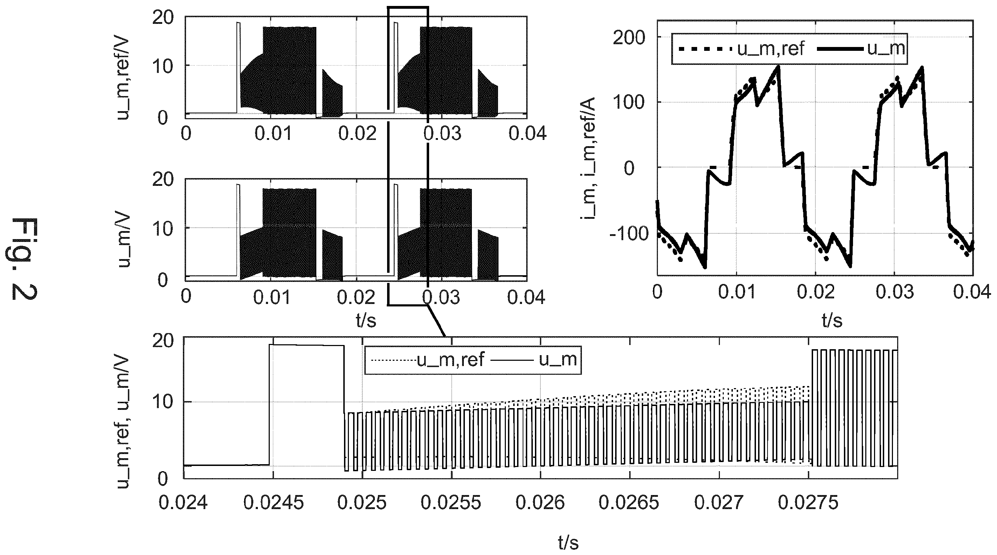

Fig. 2 zeigt einen Vergleich der berechneten Strangspannungen u_m und der berechneten Strangströme i_m für einen tatsächlich magnetisch unsymmetrischen Antrieb (Ld ungleich Lq), einmal unter der fehlerhaften Annahme eines magnetisch symmetrischen Antriebs (Anwendung von Gleichung 3, Kurven u_m, i_m) und einmal unter korrekter Berücksichtigung der magnetischen Asymmetrie des Antriebs (Anwendung von Gleichung 2, Kurven u_m,ref, i_m,ref). Die Kurvenverläufe oben links zeigen eine Strangspannung über den Zeitraum von mehr als einer Wechselrichterperiode, in der also alle Stränge alle Schaltzustände des Wechselrichters 4 zweimal durchlaufen haben. Die Spannungsverläufe u_m und u_m,ref erscheinen hier als schattierte Flächen, da die aufgelegte Spannung tatsächlich ein hochfrequentes PWM-Signal ist, die Spannung springt also zwischen der oberen und unteren Einhüllenden hin und her. In dem unteren Bild in Fig. 2 sind die beiden Spannungen u_m und u_m,ref in einem vergrößerten Ausschnitt gemeinsam dargestellt, sodass erkennbar wird, dass die Spannungen hochfrequent veränderlich sind. Auch ist in dem unteren Bild zu erkennen, dass die Berechnungen der Spannungen durchaus merklich voneinander abweichen. Dies wirkt sich auch auf die Berechnung der Ströme aus, wie im Bild oben rechts in Fig. 2 erkennbar ist, wobei i_m, ref der korrekt berechnete Strangstrom ist, also unter Berücksichtigung der magnetischen Asymmetrie des Antriebs, und wobei i_m der fehlerhaft berechnete Strangstrom ist, bei dem die magnetische Asymmetrie des Antriebs nicht berücksichtigt worden ist. Auch hier gibt es merkliche Unterschiede, die zeigen, dass die Genauigkeit der Antriebsnachbildung leidet, wenn die Voraussetzungen für eine (vereinfachte) Berechnung der Rückwirkungspotentiale nicht gegeben sind.

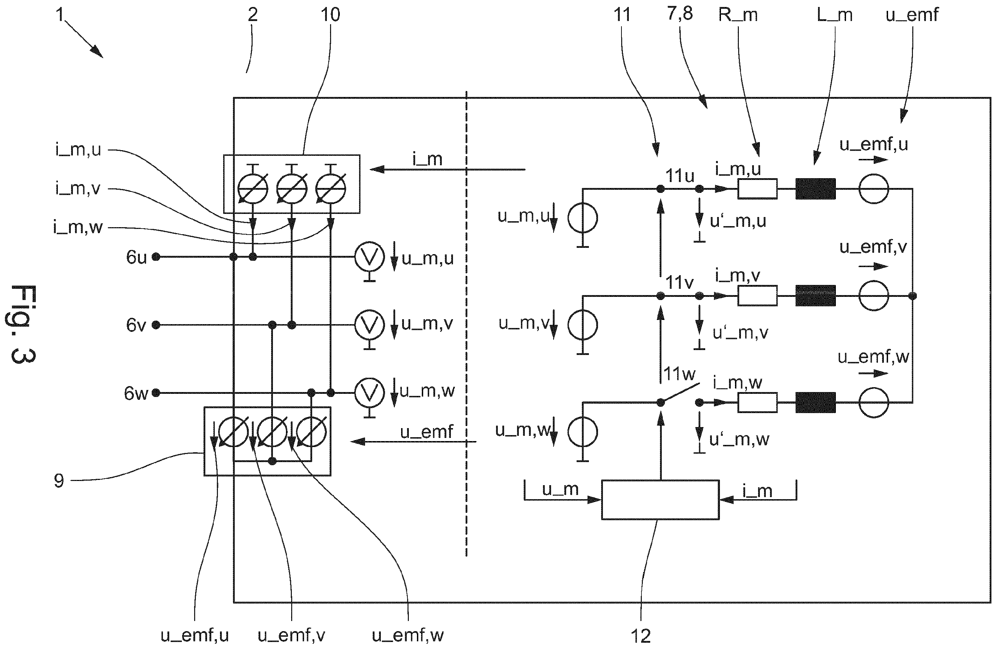

In Fig. 3 sind ein Verfahren 1 und ein Simulator 2 dargestellt, mit denen die zuvor dargestellten Auswirkungen einer fehlerhaften Berechnung der Rückwirkungspotentiale u_emf stark reduziert und sogar vermieden werden können. Die Darstellung des Simulators 2 entspricht im Wesentlichen der des Simulators 2 in Fig. 1, das Steuergerät ist jedoch weggelassen worden. Zur Lösung des Problems ist das mathematische Modell 7 des elektrischen Antriebs in den Strängen 8 jeweils durch einen virtuellen Schalter **11** ergänzt, wobei die virtuellen Schalter 11 im geöffneten Zustand den Einfluss der zugehörigen gemessenen Strangspannungen u_m auf die berechneten Stromflüsse i_m in dem jeweiligen Strang 8 reduzieren. Die virtuellen Schalter 11 in den Strängen 8 des elektrischen Antriebs werden von einer Schaltlogik 12 des Simulators 2 durch Auswertung wenigstens einer Strangspannung u_m und/oder eines Strangstromes i_m geöffnet und/oder geschlossen.

Im dargestellten Fall ist die Schaltlogik 12 des Simulators 2 so ausgestaltet, dass sie den virtuellen Schalter 11 desjenigen Strangs 8 öffnet, dessen Stranganschluss 6 potentialfrei ist. Wenn von den Gegebenheiten in Fig. 1 ausgegangen wird, dann sind die Speiseanschlüsse 5u, 5v des Steuergerätes 2 auf ein definiertes elektrisches Potential gelegt, was folglich auch für die Stranganschlüsse 6u, 6v des Simulators 2 gilt. Ferner ist der Speiseanschluss 5w des Steuergerätes 2 potentialfrei geschaltet, was dann ebenfalls für den Stranganschluss 6w des Simulators 2 gilt. Die Schaltlogik 12 hat diese Verhältnisse erkannt und folglich die virtuellen Schalter 11u und 11v geschlossen und den virtuellen Schalter 11w geöffnet.

Schalter verändern grundsätzlich die Struktur einer Schaltung, da durch Einsatz von Schaltern in der Regel Schaltungsteile aktiviert und deaktiviert werden. Damit ändert sich auch die gleichungsmäßige Beschreibung einer Schaltung, je nachdem, welche der Schalter geöffnet oder geschlossen sind, die Schaltung ist also strukturvariant und es müssen unterschiedliche mathematische Modelle zur Berechnung der Schaltung herangezogen werden.

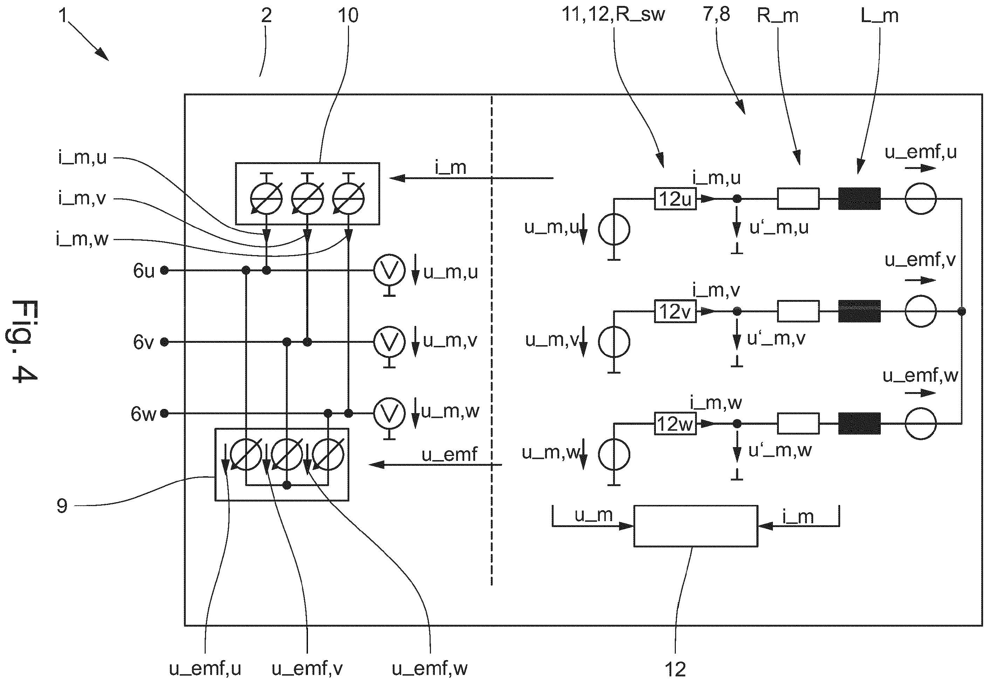

Bei der Ausgestaltung des Verfahrens 1 und des Simulators 2 gemäß Fig. 4 werden die virtuellen Schalter 11 in den Modellen der Stränge 8 des Antriebs durch jeweils einen ohmschen Widerstand 12 repräsentiert, deren Widerstandswerte R_sw vom Schaltzustand der virtuellen Schalter 11 abhängen. Dadurch wird das mathematische Modell 8 des Antriebs strukturinvariant, da sich die mathematische Beschreibung des Antriebs mit den Schaltzuständen der virtuellen 11 Schalter nicht ändert (die ohmschen Widerstände 12 sind unabhängig vom Schaltzustand immer vorhanden), lediglich Parameter des Modells, nämlich die Widerstandswerte R_sw, sind abhängig von den Schaltzuständen.

Die Wirkung der virtuellen Schalter 11 in Form der Widerstände 12 lässt sich gut darstellen, indem das Ersatzschaltbild des elektrischen Antriebs wieder gleichungsmäßig beschrieben wird, wie dies schon anhand von Fig. 1 gemacht worden ist, mit dem Unterschied, dass die Widerstandswerte R_sw der ohmschen Widerstände 12 zusätzlich berücksichtigt werden müssen. Es wird wiederum davon ausgegangen, dass der Stranganschluss 6w vom Steuergerät 3 potentialfrei geschaltet ist. Die Widerstandswerte R_sw,u und R_sw,v werden zu Null gesetzt, da die korrespondierenden Widerstände 12u und 12v geschlossene virtuelle Schalter 11u, 11v repräsentieren. Es sind zusätzlich die inneren Strangspannungen u'_m eingeführt worden, die die Spannungen direkt hinter den Widerständen 12 der virtuellen Schalter 11 kennzeichnen, wobei die Strangspannungen u_m unmittelbar an den anderen Enden der Widerstände 12 der virtuellen Schalter 11 anliegen.

Der Strom in dem voraussetzungsgemäß floatend geschalteten Strang 8w ergibt sich zu (Gleichung 4):

$$i\_m,w = \frac{u\_m,w - u'\_m,w}{R\_sw,w}$$

Für die innere Strangspannung u'_m,w des potentialfrei geschalteten Strangs 8w folgt (Gleichung 5):

$$u'\_m,w = u\_emf,w + \frac{1}{2}\left(-u\_emf,u - u\_emf,v + L\_m,u\frac{di\_m,v}{dt}\ldots\right.$$
$$\left.- L\_m,v\frac{di\_m,v}{dt} + u\_m,u + u\_m,v\right)\ldots$$
$$+ 3R\_m \cdot i\_m,w + (L\_m,u + 2L\_m,w)\frac{di\_m,w}{dt}$$

Wird der Widerstandswert R_sw,w unendlich groß gewählt, hat die fehlerhaft emulierte Rückwirkungsspannung, die dann wieder messtechnisch erfasst wird und als Eingangsgröße für das Modell 7 des elektrischen Antriebs verwendet wird, keinen Einfluss mehr auf die Stromberechnung. Aus Gleichung 4 folgt, dass i_m,w = 0 gilt. Damit wird aus Gleichung 5 (Gleichung 6):

$$u'\_m,w = u\_emf,w + \frac{1}{2}\left( -u\_emf,u - u\_emf,v + L\_m,u\frac{di\_m,v}{dt} \ldots \right.$$
$$\left. - L\_m,v\frac{di\_m,v}{dt} + u\_m,u + u\_m,v \right)$$

Gleichung 6 entspricht dem allgemeinen Ergebnis gemäß Gleichung 2 und stellt daher eine richtige Lösung für einen magnetisch unsymmetrischen elektrischen Antrieb dar (in rotorfesten Koordinaten gleichbedeutend mit Ld ungleich Lq).

In der numerischen Realität kann der Widerstandswert R_sw,w nicht unendlich groß gewählt werden, deshalb ist der Strangstrom i_m,w nicht gleich Null. In dem Ausführungsbeispiel gemäß Fig. 4 erfolgt die Berechnung nicht gemäß Gleichung 6, sondern gemäß Gleichung 4 nach Umstellung nach u'_m,w.

Die Schaltlogik 12, die für die zeitrichtige Betätigung der Schalter 11 bzw. für die zeitrichtige Änderung der Widerstandswerte R_sw der ohmschen Widerstände 12 sorgt, wird in Fig. 4 so umgesetzt wie die an sich bekannte Erkennung des Beschaltungswechsels an einem Strang, aufgrund derer der Spannungsemulator 9 und der Stromemulator 10 angewiesen werden, die potentialbehafteten Stränge zu bestromen und den vom Steuergerät 3 freigeschalteten, floatenden Strang mit dem Rückwirkungspotential u_emf zu beaufschlagen.

Eine Variante des Verfahrens 1 und des Simulators 2, die hier im Einzelnen nicht detailliert dargestellt ist, sieht vor, dass die Schaltlogik 12 des Simulators 2 auswertet, ob eine Voraussetzung für die korrekte Ermittlung des Rückwirkungspotentials u_emf,w am potentialfreien Stranganschluss 6w im tatsächlichen Betriebszustand des elektrischen Antriebs erfüllt ist und bei Nichterfüllung der Voraussetzung für die korrekte Ermittlung des Rückwirkungspotentials u_emf den virtuellen Schalter 11w desjenigen Strangs 8w öffnet, dessen Stranganschluss 6w potentialfrei ist. Konkret wird als Voraussetzung für die korrekte Ermittlung des Rückwirkungspotentials u_emf am potentialfreien Stranganschluss 6w gewählt, dass der elektrische Antrieb magnetisch symmetrisch ist.

Bei dem Verfahren 1 und dem Simulator 2 gemäß Fig. 4 werden die Widerstandswerte R_sw der virtuellen Schalter 11 in Form der ohmschen Widerstände 12 für den offenen und den geschlossenen Schaltzustand so gewählt, dass das mathematische Modell 7 des elektrischen Antriebs mit expliziten numerischen Lösungsverfahren stabil gelöst werden kann. Die Werte werden unter Berücksichtigung einer vorgegebenen Berechnungsschrittweite ausgewählt, insbesondere so, dass die Berechnung in Echtzeit durchgeführt werden kann.

Bezugszeichen

| | |
|---|---|
| 1 | computerimplementiertes Verfahren |
| 2 | Hardware-in-the-Loop-Simulator |
| 3 | Steuergerät |
| 4 | Wechselrichter des Steuergeräts |
| 5 | Speiseanschlüsse des Steuergeräts |
| 5u, 5v | nicht potentialfreie Speiseanschlüsse |
| 5w | potentialfreier Speiseanschluss |
| 6 | Stranganschlüsse des Simulators |
| 6u, 6v | nicht potentialfreie Stranganschlüsse |
| 6w | potentialfreier Stranganschluss |
| 7 | mathematisches Modell des elektrischen Antriebs |
| 8 | mathematisches Modell der Stränge des Antriebs |
| 9 | Spannungsemulator |
| 10 | Stromemulator |
| 11 | virtuelle Schalter |
| 12 | Schaltlogik zur Betätigung der virtuellen Schalter |

| | |
|---|---|
| U_DC | Zwischenkreisspannung |
| u_m | Strangspannungen |
| i_m | Strangströme |
| R_m | Strangwiderstand |
| L_m | Stranginduktivität |
| u_st | Sternspannung |

u_emf    elektrisches Rückwirkungspotential
R_sw    ohmscher Widerstand zur Nachbildung virtueller Schalter
u'_m    innere Strangspannung

**Patentansprüche**

1. Computerimplementiertes Verfahren (1) zur Simulation eines mehrphasigen elektrischen Antriebs mit bestrombaren Strängen mittels eines Hardware-in-the-Loop-Simulators (2) zum Test eines leistungselektronischen Steuergeräts (3) mit integriertem Wechselrichter (4), wobei das Steuergerät (3) wenigstens drei Speiseanschlüsse (5) aufweist und der Wechselrichter (4) des Steuergeräts(3) im Testbetrieb in zeitlichen Abschnitten einen Speiseanschluss (5u) der drei Speiseanschlüsse (5) auf ein hohes Wechselrichterpotential schaltet, einen anderen Speiseanschluss (5v) der drei Speiseanschlüsse (5) auf ein niedriges Wechselrichterpotential schaltet und noch einen anderen Speiseanschluss (5w) der drei Speiseanschlüsse (5) potentialfrei schaltet, wobei im Testbetrieb die Speiseanschlüsse (5) des Steuergeräts (3) mit korrespondierenden Stranganschlüssen (6) des Simulators (2) verbunden sind, wobei die Strangspannungen (u_m) der Stranganschlüsse (6) im Simulator (2) messtechnisch erfasst werden, wobei der Simulator (2) mit einem mathematischen Modell (7) des elektrischen Antriebs und dessen Strängen (8) anhand der gemessenen Strangspannungen (u_m) korrespondierende Strangströme (i_m) des Antriebs berechnet, wobei im Simulator (2) durch Auswertung der Strangspannungen (u_m) und/oder der Strangströme (i_m) ermittelt wird, welcher Stranganschluss (6) mit dem potentialfreien Speiseanschluss (5w) des Steuergeräts (3) verbunden und daher ein potentialfreier Stranganschluss (6w) ist, wobei der Simulator (2) ein sich aus der Antriebsrückwirkung ergebendes elektrisches Rückwirkungspotential (u_emf,w) des potentialfreien Stranganschlusses (6w) ermittelt und mittels eines Spannungsemulators (9) den potentialfreien Stranganschluss (6w) auf das ermittelte Rückwirkungspotential (u_emf,w) legt und wobei der Simulator (2) in die nicht potentialfreien Stranganschlüsse (6u), (6v) die berechneten Strangströme (i_m,u), (i_m,v) mittels eines Stromemulators (10) einspeist,

   **dadurch gekennzeichnet,**

   **dass** das mathematische Modell (7) des elektrischen Antriebs in den Strängen (8) jeweils durch einen virtuellen Schalter (11) ergänzt ist, wobei die virtuellen Schalter (11) im geöffneten Zustand den Einfluss der zugehörigen gemessenen Strangspannungen (u_m) auf die berechneten Stromflüsse (i_m) in dem jeweiligen Strang (8) reduzieren,
   wobei die virtuellen Schalter (11) in den Strängen (8) des elektrischen Antriebs von einer Schaltlogik (12) des Simulators (2) durch Auswertung wenigstens einer Strangspannung (u_m) und/oder eines Strangstromes (i_m) geöffnet und/oder geschlossen werden.

2. Verfahren (1) nach Anspruch 1, **dadurch gekennzeichnet, dass** der virtuelle Schalter (11) in dem Modell eines Strangs (8) des Antriebs durch einen ohmschen Widerstand (12) repräsentiert wird, dessen Widerstandswert (R sw) vom Schaltzustand des virtuellen Schalters (11) abhängt.

3. Verfahren (1) nach Anspruch 1 oder 2, **dadurch gekennzeichnet, dass** die Schaltlogik (12) des Simulators (2) den virtuellen Schalter (11w) desjenigen Strangs (8w) öffnet, dessen Stranganschluss (6w) potentialfrei ist.

4. Verfahren (1) nach Anspruch 3, **dadurch gekennzeichnet, dass** die Schaltlogik (12) des Simulators (2) auswertet, ob eine Voraussetzung für die korrekte Ermittlung des Rückwirkungspotentials (u emf,w) am potentialfreien Stranganschluss (6w) im tatsächlichen Betriebszustand des elektrischen Antriebs erfüllt ist und bei Nichterfüllung der Voraussetzung für die korrekte Ermittlung des Rückwirkungspotentials (u emf) den virtuellen Schalter (11w) desjenigen Strangs (8w) öffnet, dessen Stranganschluss (6w) potentialfrei ist.

5. Verfahren (1) nach Anspruch 4, **dadurch gekennzeichnet, dass** eine Voraussetzung für die korrekte Ermittlung des Rückwirkungspotentials (u emf) am potentialfreien Stranganschluss (6w) ist, dass der elektrische Antrieb magnetisch symmetrisch ist.

6. Verfahren (1) nach einem der Ansprüche 1 bis 5, **dadurch gekennzeichnet, dass** die Widerstandswerte (R sw) der virtuellen Schalter (11) in Form der ohmschen Widerstände (12) für den offenen und den geschlossenen Schaltzustand so gewählt werden, dass das mathematische Modell (7) des elektrischen Antriebs mit expliziten numerischen Lösungsverfahren stabil gelöst werden kann, insbesondere bei vorgegebener Berechnungsschrittweite, vorzugsweise unter Echtzeitbedingungen.

7. Verfahren (1) nach einem der Ansprüche 1 bis 6, **dadurch gekennzeichnet, dass** der simulierte elektrische Antrieb eine mehrphasige, insbesondere dreiphasige, permanenterregte Synchronmaschine ist, insbesondere ein bürstenloser Gleichstrommotor ist.

8. Hardware-in-the-Loop Simulator (2) zur computerimplementierten Simulation eines mehrphasigen elektrischen Antriebs mit bestrombaren Strängen zum Test eines leistungselektronischen Steuergeräts (3) mit integriertem Wechselrichter (4), wobei das Steuergerät (3) wenigstens drei Speiseanschlüsse (5) aufweist und der Wechselrichter (4) des Steuergeräts (3) im Testbetrieb in zeitlichen Abschnitten einen Speiseanschluss (5u) der drei Speiseanschlüsse (5) auf ein hohes Wechselrichterpotential schaltet, einen anderen Speiseanschluss (5v) der drei Speiseanschlüsse (5) auf ein niedriges Wechselrichterpotential schaltet und noch einen anderen Speiseanschluss (5w) der drei Speiseanschlüsse (5) potentialfrei schaltet, wobei im Testbetrieb die Speiseanschlüsse (5) des Steuergeräts (3) mit korrespondierenden Stranganschlüssen (6) des Simulators (3) verbunden sind, wobei die Strangspannungen (u_m) der Stranganschlüsse (6) im Simulator (2) messtechnisch erfasst werden, wobei der Simulator (2) mit einem mathematischen Modell (7) des elektrischen Antriebs und dessen Strängen (8) anhand der gemessenen Strangspannungen (u_m) korrespondierende Strangströme (i_m) des Antriebs berechnet, wobei im Simulator (2) durch Auswertung der Strangspannungen (u_m) und/oder der Strangströme (i_m) ermittelt wird, welcher Stranganschluss (6) mit dem potentialfreien Speiseanschluss (5w) des Steuergeräts (3) verbunden und daher ein potentialfreier Stranganschluss (6w) ist, wobei der Simulator (2) das sich aus der Antriebsrückwirkung ergebende elektrische Rückwirkungspotential (u_emf) des potentialfreien Stranganschlusses (6w) ermittelt und mittels eines Spannungsemulators (9) den potentialfreien Stranganschluss (6w) auf das ermittelte Rückwirkungspotential (u_emf,w) legt und wobei der Simulator (2) in die nicht potentialfreien Stranganschlüsse (6u, 6v) die berechneten Strangströme (i_m,u), (i_m,v) mittels eines Stromemulators (10) einspeist,
**dadurch gekennzeichnet,**
**dass** der Simulator (2) so ausgestaltet ist, dass er im Testbetrieb, also mit angeschlossenem leistungselektronischem Steuergerät (3), das Verfahren (1) nach einem der Ansprüche 1 bis 7 durchführt.

9. Computerprogramm, umfassend Befehle, die bei der Ausführung des Programms durch eine Recheneinheit eines Hardware-in-the-Loop-Simulators (2) diese veranlassen, das Verfahren (1) nach einem der Ansprüche 1 bis 7 auszuführen.

## Claims

1. Computer-implemented method (1) for simulating a multiphase electric drive with energisable strings by means of a hardware-in-the-loop simulator (2) for testing a power-electronic control unit (3) with integrated inverter (4), wherein the control device (3) has at least three supply terminals (5) and the inverter (4) of the control device (3) switches one supply terminal (5u) of the three supply terminals (5) to a high inverter potential in test mode at timed intervals, switches another supply connection (5v) of the three supply connections (5) to a low inverter potential and switches another supply connection (5w) of the three supply connections (5) potential-free, wherein in test operation the supply connections (5) of the control device (3) are connected to corresponding string connections (6) of the simulator (2), wherein the string voltages (u_m) of the string connections (6) in the simulator (2) are detected by measurement, wherein the simulator (2) uses a mathematical model (7) of the electric drive and its strings (8) to calculate corresponding string currents (i_m) of the drive on the basis of the measured string voltages (u_m), wherein the simulator (2) determines which string connection (6) is connected to the potential-free supply connection (5w) of the control unit (3) and is therefore a potential-free string connection (6w) by evaluating the string voltages (u_m) and/or the string currents (i_m), wherein the simulator (2) determines an electrical feedback potential (u_emf,w) of the potential-free line connection (6w) resulting from the drive feedback and, by means of a voltage emulator (9), applies the potential-free line connection (6w) to the determined feedback potential (u_emf,w) and wherein the simulator (2) feeds the calculated phase currents (i_m,u), (i_m,v) into the non-potential-free phase connections (6u), (6v) by means of a current emulator (10),
**characterised in that**

the mathematical model (7) of the electric drive in the strings (8) is supplemented in each case by a virtual switch (11), the virtual switches (11) in the open state reducing the influence of the associated measured string voltages (u_m) on the calculated current flows (i_m) in the respective string (8),
wherein the virtual switches (11) in the strings (8) of the electric drive are opened and/or closed by a switching logic (12) of the simulator (2) by evaluating at least one string voltage (u_m) and/or one string current (i_m).

2. Method (1) according to claim 1, **characterised in that** the virtual switch (11) in the model of a line (8) of the drive is represented by an ohmic resistor (12), the resistance value (R_sw) of which depends on the switching state of the virtual switch (11).

3. Method (1) according to claim 1 or 2, **characterised in that** the switching logic (12) of the simulator (2) opens the virtual switch (11w) of the respective line (8w) whose line connection (6w) is potential-free.

4. Method (1) according to claim 3, **characterised in that** the switching logic (12) of the simulator (2) evaluates whether a prerequisite for the correct determination of the feedback potential (u_emf,w) at the potential-free line connection (6w) is fulfilled in the actual operating state of the electric drive and, if the prerequisite for the correct determination of the feedback potential (u_emf) is not fulfilled, opens the virtual switch (11w) of the line (8w) whose line connection (6w) is potential-free.

5. Method (1) according to claim 4, **characterised in that** a prerequisite for the correct determination of the feedback potential (u_emf) at the potential-free string connection (6w) is that the electric drive is magnetically symmetrical.

6. Method (1) according to one of claims 1 to 5, **characterised in that** the resistance values (R_sw) of the virtual switches (11) in the form of the ohmic resistances (12) for the open and the closed switching state are selected such that the mathematical model (7) of the electric drive can be solved in a stable manner using explicit numerical solution methods, in particular with a predetermined calculation step size, preferably under real-time conditions.

7. Method (1) according to one of claims 1 to 6, **characterised in that** the simulated electric drive is a multiphase, in particular three-phase, permanently excited synchronous machine, in particular a brushless DC motor.

8. Hardware-in-the-loop simulator (2) for computer-implemented simulation of a multiphase electric drive with energisable strings for testing a power-electronic control device (3) with integrated inverter (4), wherein the control device (3) has at least three supply connections (5) and the inverter (4) of the control device (3) switches one supply connection (5u) of the three supply connections (5) to a high inverter potential in time intervals during test operation, switches another supply connection (5v) of the three supply connections (5) to a low inverter potential and switches another supply connection (5w) of the three supply connections (5) potential-free, wherein in test mode the supply connections (5) of the control device (3) are connected to corresponding string connections (6) of the simulator (3), wherein the string voltages (u_m) of the string connections (6) in the simulator (2) are detected by measurement, wherein the simulator (2) uses a mathematical model (7) of the electric drive and its strings (8) to calculate corresponding string currents (i_m) of the drive on the basis of the measured string voltages (u_m), wherein in the simulator (2), by evaluating the phase voltages (u_m) and/or the phase currents (i_m), it is determined which phase connection (6) is connected to the potential-free supply connection (5w) of the control unit (3) and is therefore a potential-free phase connection (6w), wherein the simulator (2) determines the electrical feedback potential (u_emf) of the potential-free line connection (6w) resulting from the drive feedback and, by means of a voltage emulator (9), applies the potential-free line connection (6w) to the determined feedback potential (u_emf,w) and wherein the simulator (2) feeds the calculated string currents (i_m,u), (i_m,v) into the non-potential-free string connections (6u, 6v) by means of a current emulator (10),
characterised in thatthe simulator (2) is designed in such a way that it carries out the method (1) according to one of claims 1 to 7 in test mode, i.e. with the power electronic control unit (3) connected.

9. Computer program comprising instructions which, when the program is executed by a computing unit of a hardware-in-the-loop simulator (2), cause the latter to execute the method (1) according to one of claims 1 to 7.


**Revendications**

1. Procédé (1) mis en œuvre par ordinateur pour simuler un entraînement électrique polyphasé avec des branches pouvant être alimentées en courant au moyen d'un simulateur Hardware-in-the-Loop (2) pour tester un appareil de commande (3) électronique de puissance avec onduleur (4) intégré, l'appareil de commande (3) présentant au moins trois connexions d'alimentation (5) et l'onduleur (4) de l'appareil de commande (3) commutant en mode de test, par intervalles de temps, une connexion d'alimentation (5u) des trois connexions d'alimentation (5) à un potentiel d'onduleur élevé, commute une autre borne d'alimentation (5v) des trois bornes d'alimentation (5) à un potentiel d'onduleur bas et commute encore une autre borne d'alimentation (5w) des trois bornes d'alimentation (5) sans potentiel, les bornes d'alimentation (5) de l'appareil de commande (3) étant reliées, en mode de test, à des bornes de branche (6) correspondantes du simulateur (2), les tensions de branche (u_m) des bornes de branche (6) étant détectées dans le simulateur (2) par une technique de mesure, le simulateur (2) calculant, avec un modèle mathématique (7) de l'entraînement électrique et de ses branches (8), à l'aide des tensions de branche (u_m) mesurées, des courants de branche (i_m) correspondants de l'entraînement, le simulateur (2) déterminant, par évaluation des tensions de branche (u_m) et/ou des courants de branche (i_m), quel raccordement de branche (6) est relié au raccordement d'alimentation (5w) libre de potentiel de l'appareil de commande (3) et est donc un raccordement de branche (6w) libre de potentiel, le simulateur (2) déterminant un potentiel électrique de rétroaction (u_emf,w) du raccordement de branche sans potentiel (6w) résultant de la rétroaction d'entraînement et appliquant au moyen d'un émulateur de tension (9) le raccordement de branche sans potentiel (6w) au potentiel de rétroaction déterminé (u_emf,w) et dans lequel le simulateur (2) injecte les courants de branche calculés (i_m,u), (i_m,v) dans les raccordements de branche non libres de potentiel (6u), (6v) au moyen d'un émulateur de courant (10), **caractérisé en ce que**

le modèle mathématique (7) de l'entraînement électrique est complété dans les branches (8) respectivement par un commutateur virtuel (11), les commutateurs virtuels (11) réduisant à l'état ouvert l'influence des tensions de branche (u_m) mesurées associées sur les flux de courant (i_m) calculés dans la branche (8) respective, les commutateurs virtuels (11) dans les branches (8) de l'entraînement électrique étant ouverts et/ou fermés par une logique de commutation (12) du simulateur (2) par évaluation d'au moins une tension de branche (u_m) et/ou d'un courant de branche (i_m).

2. Procédé (1) selon la revendication 1, **caractérisé en ce que** le commutateur virtuel (11) est représenté dans le modèle d'une branche (8) de l'entraînement par une résistance ohmique (12) dont la valeur de résistance (R_sw) dépend de l'état de commutation du commutateur virtuel (11).

3. Procédé (1) selon la revendication 1 ou 2, **caractérisé en ce que** la logique de commutation (12) du simulateur (2) ouvre le commutateur virtuel (11w) de la branche (8w) dont le raccordement de branche (6w) est libre de potentiel.

4. Procédé (1) selon la revendication 3, **caractérisé en ce que** la logique de commutation (12) du simulateur (2) évalue si une condition pour la détermination correcte du potentiel de rétroaction (u_emf, w) au niveau du raccordement de branche (6w) libre de potentiel est remplie dans l'état de fonctionnement réel de l'entraînement électrique et, si la condition pour la détermination correcte du potentiel de rétroaction (u_emf) n'est pas remplie, ouvre le commutateur virtuel (11w) de la branche (8w) dont le raccordement de branche (6w) est libre de potentiel.

5. Procédé (1) selon la revendication 4, **caractérisé en ce qu'**une condition préalable à la détermination correcte du potentiel de réaction (u_emf) au niveau de la connexion de branche sans potentiel (6w) est que l'entraînement électrique soit magnétiquement symétrique.

6. Procédé (1) selon l'une des revendications 1 à 5, **caractérisé en ce que** les valeurs de résistance (R_sw) des commutateurs virtuels (11) sous forme de résistances ohmiques (12) pour l'état de commutation ouvert et fermé sont choisies de telle sorte que le modèle mathématique (7) de l'entraînement électrique puisse être résolu de manière stable par des procédés de résolution numérique explicites, en particulier pour un pas de calcul prédéfini, de préférence dans des conditions de temps réel.

7. Procédé (1) selon l'une des revendications 1 à 6, **caractérisé en ce que** l'entraînement électrique simulé est une machine synchrone polyphasée, en particulier triphasée, à excitation permanente, notamment un moteur à courant continu sans balais.

8. Simulateur Hardware-in-the-Loop (2) pour la simulation mise en œuvre par ordinateur d'un entraînement électrique polyphasé avec des branches pouvant être alimentées en courant pour tester un appareil de commande (3) électronique de puissance avec onduleur (4) intégré, l'appareil de commande (3) présentant au moins trois connexions d'alimentation (5) et l'onduleur (4) de l'appareil de commande (3) commutant, en mode de test, par intervalles de temps, une connexion d'alimentation (5u) des trois connexions d'alimentation (5) à un potentiel d'onduleur élevé, commute une autre borne d'alimentation (5v) des trois bornes d'alimentation (5) à un potentiel d'onduleur bas et commute encore une autre borne d'alimentation (5w) des trois bornes d'alimentation (5) sans potentiel, les bornes d'alimentation (5) de l'appareil de commande (3) étant reliées, en mode de test, à des bornes de branche (6) correspondantes du simulateur (3), les tensions de branche (u_m) des bornes de branche (6) étant détectées dans le simulateur (2) par une technique de mesure, le simulateur (2) calculant, à l'aide d'un modèle mathématique (7) de l'entraînement électrique et de ses branches (8), les courants de branche (i_m) correspondants de l'entraînement à l'aide des tensions de branche (u_m) mesurées, le simulateur (2) déterminant, par l'évaluation des tensions de branche (u_m) et/ou des courants de branche (i_m), quel raccordement de branche (6) est relié au raccordement d'alimentation libre de potentiel (5w) de l'appareil de commande (3) et est donc un raccordement de branche libre de potentiel (6w), le simulateur (2) déterminant le potentiel électrique de rétroaction (u_emf) du raccordement de branche sans potentiel (6w) résultant de la rétroaction d'entraînement et appliquant, au moyen d'un émulateur de tension (9), le raccordement de branche sans potentiel (6w) au potentiel de rétroaction déterminé (u_emf,w) et dans lequel le simulateur (2) injecte les courants de branche calculés (i_m,u), (i_m,v) dans les raccordements de branche non libres de potentiel (6u, 6v) au moyen d'un émulateur de courant (10),

**caractérisé en ce que**

le simulateur (2) est configuré de manière à mettre en œuvre le procédé (1) selon l'une des revendications 1 à 7 en mode test, c'est-à-dire avec un appareil de commande électronique de puissance (3) connecté.

9. Programme informatique comprenant des instructions qui, lors de l'exécution du programme par une unité de calcul d'un simulateur Hardware-in-the-Loop (2), amènent celle-ci à exécuter le procédé (1) selon l'une des revendications 1 à 7.

Fig. 1

Fig. 2

Fig. 3

Fig. 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2023359785 A1